# EUROPEAN PATENT SPECIFICATION

(11) **EP 1 969 722 B1**
(45) Date of publication and mention of the grant of the patent: **01.07.2009**
(21) Application number: 06829412.3
(22) Date of filing: 04.12.2006
(51) Int. Cl.: H03K 17/082, H03K 17/16, H03K 17/042

(54) **OPERATING ELECTRONIC SWITCHES HAVING AN INSULATED GATE**
BETRIEB ELEKTRONISCHER SCHALTER MIT EINEM ISOLIERTEN GATE
COMMUTATEURS ELECTRONIQUES OPERATIONNELS A PORTE ISOLEE

(30) Priority: 13.12.2005 GB 0525316
(43) Date of publication of application: 17.09.2008
(73) Proprietor: Bombardier Transportation GmbH, 10785 Berlin (DE)
(72) Inventor: BELWON, Waldemar, S-722 41 Västeras (SE); WENNERLUND, Per, S-722 26 Västeras (SE)
(74) Representative: Patentanwälte Bressel und Partner
(86) International application number: PCT/EP2006/011800
(87) International publication number: WO 2007/068396

(56) References cited:
- WO-A-98/10301
- WO-A-20/05104743
- DE-A1- 10 217 611
- DE-A1- 19 634 612
- US-B1- 6 400 106
- ECKEL H-G ET AL: "Optimization of the turn-off performance of IGBT at overcurrent and short-circuit current" PROCEEDINGS OF THE 5TH EUROPEAN CONFERENCE ON POWER ELECTRONICS AND APPLICATIONS, 1993, pages 317-322, XP006511564

## Description

The invention relates to the operation of electronic valves having an insulated gate, in particular operation of an IGBT (insulated Gate Bipolar Transistor). More particularly, the invention relates to high-power converters comprising such valves, e.g. for delivering electric energy to a driving motor of a railroad traction vehicle. Furthermore, the invention relates to a corresponding arrangement. The term "gate" includes any electrically insulated control electrode which is used to control the switching state of the valve.

Usually, converters comprise a plurality of electronic valves which are repeatedly switched on and off during operation of the converter in order to perform a current and/or voltage conversion. The switching process of each of the electronic valves is controlled by a valve control unit which is directly connected to the electronic valve. In particular, the converter may be a DC (direct current) to AC (alternating current) converter which performs a conversion of a direct current into an alternating current and/or vice versa. More particularly, the invention relates to the field of converters for high-power applications such as providing electric energy to driving motors of railroad traction vehicles.

Converters of the type indicated before are well known in practice. For example, the converter may be a DC to AC converter, wherein the DC-side of the converter (first converter) is connected via a DC intermediate circuit to an AC to DC converter (second converter) which is connected to an AC power supply network. The AC-side of the first converter may be connected to a three-phase alternating current load, such as an asynchronous motor. A converter control device is provided which controls the operation of the electronic valves of the converter, thereby controlling the operation of the converter. There is a valve control unit for each of the valves and each of the valve control units is connected to the converter control device. For fast transfer of control signals, which are transferred from the converter control device to the valve control units, the control signals may be light pulse signals in an optical signal line, such as a glass fibre cable. Corresponding signal converters for conversion of analogue or digital signals into optical signals or vice versa are provided for the converter control device and for the valve control units.

The controlling of such a converter usually requires information about the phase currents on the AC-side of the converter. Typically, current transformers are used to measure the phase currents. In recent times, Hall Effect measurement devices have been introduced. However, costs and effort for producing and mounting such measurement devices as well as for corresponding cabling are high. In addition, a Hall Effect measurement device requires power supply. Furthermore, redundant measurement devices may be necessary in order to guarantee the operation of the converter.

Eckel H-G et al: "Optimization of the turn-off performance of IGBT at overcurrent and short-circuit current" proceedings of the 5th European Conference on Power electronics and applications, 1993, pages 317 - 322 discloses a two-stage gate control for the IGBT, which allows a reduction of the overvoltage at overcurrent turn-off without increasing the switching losses at nominal current. According to this publication, the turn-off behaviour of the IGBT can be influenced by the gate discharge current. At first, the gate is discharged until the gate-emitter voltage reaches the miller-plateau. During this time, the collector-emitter voltage rises only slightly (saturation characteristic of the IGBT). In the second period, the collector-emitter voltage rises. The gate control with current dependent switch-over of the gate resistance uses the current dependence of the miller-plateau to detect overcurrent and short-circuit current. At high collector current, the miller-plateau of the gate-emitter voltage is high. After a delay time has lapsed, the gate resistance is turned off and a larger gate resistance is turned on.

It is an object of the present invention to provide a method which allows for the measurement of the current carried by the valve (the valve current) at reduced effort and costs. It is another object to provide a corresponding arrangement.

Furthermore, it is an object of the present invention to improve the switching of the valve.

The term "valve current" is understood to be the current which flows through the valve when the valve is open. When the valve is fully open, the maximum possible valve current can flow. When the valve is closed, no valve current can flow.

In practice, the valve may be an IGBT (Insulated Gate Bipolar Transistor). However, any other valve having an insulated gate (such as a Metal Oxide Field Effect Transistor, MOSFET) which can be used to control the opening or closing of the valve may be used as well in connection with the invention.

It is a basic idea of the present invention to evaluate the following physical effect: when the valve is fully open, the charge carried by the Gate is usually saturated. This means that a charge can be withdrawn from the gate without having a significant effect on the operation state of the valve, i.e. the valve current is not affected and the collector emitter voltage is still approximately zero. However, the amount of the charge, which can be withdrawn until the operation state of the valve is affected (i.e. the gate charge is de-saturated), depends on the size of the valve current. This is true in particular when the valve is repeatedly switched on and off and therefore the gate is repeatedly charged and discharged.

According to a preferred embodiment of the invention, a constant current is used to discharge the gate and the time interval during which the constant discharging current flows is determined. In particular, the time interval may start when the valve control unit receives a trigger signal which triggers the start of the process of closing the valve from an external device, such as from a converter control device. In addition, the end of the time interval may be defined by a predetermined operating state of the valve, for example when the collector emitter voltage reaches a predetermined threshold value. For example, the time interval might be measured by a counter which is connected to a clock that periodically outputs clock signals. However, other methods of determining the time interval may be used alternatively.

One advantage of using a constant discharging current is the high precision of the measurement result. Another advantage is that there are existing types of valve control units (so called Gate Drive Units, GDU) which comprise a high-precision current source amplifier that is able to produce a highly constant discharging current. Furthermore, these types of valve control units also comprise other elements and units which can be used for the measurement of the amount of charge which is withdrawn from the gate, for example, a digital processing unit (such as a field programmable gate array, FPGA, an Application-Specific Integrated Circuit, ASIC, or a Complex Programmable Logic Device, CPLD) a counter, a comparator and a signal converter as well as a signal output and input for signal communication to and from a converter control device.

A further basic idea of the present invention is to use the measurement result for further control of the same or at least one of the following processes of closing the valve. In particular, the valve control unit can adapt the size of the discharging current, the discharging voltage and/or adapt the timing of the discharging process depending on the measurement result. For example, a very simple logic is sufficient to choose the discharging current depending on the measurement result. Highly reproducible behaviour of the collector emitter voltage during the cause of the closing process can be obtained. As a result, the precision of the timing of the switching process can be increased and, therefore, switching losses and switching safety can be improved.

Additional measurement devices, such as a Hall Effect measurement device, can be omitted. Corresponding cabling and installation effort can be saved as well. The power supply system of the converter control arrangement can be simpler and smaller dimensioned. The weight can also be reduced.

In particular, the method of measuring the valve current may be performed when the valve is fully open. According to a preferred embodiment, the measurement is started at the same time when the process of closing the valve is started. During this initial phase of the closing process, the valve current can still freely flow through the valve (ON-state). When the valve is fully open, the gate carries an electric gate charge, either a positive or a negative charge depending on the type of valve. During the initial phase (which may be referred to as "first phase"), an amount of the gate charge is withdrawn from the gate and the amount, or a quantity which depends on the amount, is measured.

The valve current is determined depending on the measured amount or depending on the other quantity. The term "determination" is not restricted to the calculation of an absolute value of the valve current. Rather, a level of the valve current may be determined in relation to a preceding level. More generally speaking, a measure for the valve current may be determined and this measure may be used in a process of controlling the valve, for example.

The measurement may start at a first predefined operating state of the valve and/or at a first point in time which is the time of starting the discharging of the gate or which differs from the starting time by a fixed amount of time.

Preferably, the measurement is performed in each of a plurality of valve control units of a converter and the results of the measurements of the valve control units are transferred to the converter control device. For example, the converter comprises three branches, wherein each of the branches comprises a series connection of two of the valves, wherein each of the branches is connected to a DC voltage and wherein a contact of each of the branches, in between the two valves, is connected to an AC-side of the converter. In this case, each of the valve control units can measure the respective valve current if the corresponding controlled valve is in its ON state and if the other valve of the same branch is in the OFF state. For example, the converter control device might process the measurement values received from the different valves of the same branch and might control the switching of these valves based on the measurement values received from both valves.

In particular for the purpose of a continuous operation, the converter control device may repeatedly receive measured values from the at least one valve control unit and may use at least some of the received values for controlling the operation of the plurality of valve control units.

The at least one valve control unit may produce a measurement signal which represents the measured value and the signal may be converted into a digital signal and/or into a pulse signal (for example: a light pulse signal) which is transferred to the converter control device.

Furthermore, the invention includes an arrangement of measuring a current (valve current) which is carried by an electronic valve having an electrically insulated control electrode (gate) which can be used to control a switching of the valve, in particular of an Insulated Gate Bipolar Transistor (IGBT). The arrangement comprises:
- a discharging unit which comprises a contact to be connected with the gate and which is adapted to drive a discharging current from the gate;
- a measurement unit which is adapted to measure an amount of a charge (gate charge) which is withdrawn from the gate or to measure another quantity which depends on the withdrawn amount;
- a starting unit which is adapted to start the measurement of the amount or of the other quantity, when the valve is fully open;
- a stopping unit which is adapted to stop the measurement of the amount or of the other quantity, when a predetermined event occurs.

The arrangement may comprise a valve control unit which includes the measurement unit or which is connected to the measurement unit. The valve control unit may be adapted to control a process of closing the valve by controlling a further discharging of the gate depending on the result of the measurement performed by the measurement unit.

The measurement unit may comprise a time measurement unit which is adapted to determine at least the end of a time interval, during which the amount of the gate charge is withdrawn from the gate. "At least" means that the start of the time interval can be determined as well. In particular, the start and stop of the time interval can be triggered using corresponding signals. For example a counter receives the signals and determines the start and stop of the time interval by starting the counting process or by stopping the counting process.

In particular, the time measurement unit may be connected to a signal input for receiving a trigger signal which triggers the start of a process of discharging the gate.

The stopping unit may comprise a comparator which is connected to a source of a reference signal and which is adapted to compare the reference signal with a signal that represents an operating state of the valve.

Furthermore, the invention includes an arrangement of operating a converter, which comprises the arrangement described before. The converter comprises a plurality of electronic valves which are repeatedly switched on and off during operation of the converter in order to perform a conversion, in particular a conversion of a direct current into an alternating current and/or vice versa. An output of the measurement unit is connected to a converter control device which is connected to each of a plurality of valve control units and which is adapted to control an operation of the plurality of valve control units, thereby operating the converter.

Each of the valve control units may comprise one embodiment of the measurement unit.

Compared to conventional arrangements, only minor amendments to the hardware are necessary. In particular, the measurement signal can be transferred from the valve control unit to the converter control device. However, since there are usually signal lines for transferring signals from the valve control units to the converter control device, the additional effort is low. The corresponding insulation requirements regarding the electrical insulation between the measurement device in the valve control unit on one hand and the signal line on the other hand are fulfilled by existing solutions. Thus, the additional costs are low.

An existing type of measurement device in the valve control unit may comprise a resistive voltage divider, wherein this divider arrangement is adapted to measure the collector emitter voltage. Therefore, the collector emitter voltage can be used to determine the end of the time interval (in particular the end of the initial phase of discharging the gate). The voltage measurement result can be transferred to the converter control device.

An example of the present invention (which corresponds to the best mode of the invention) will be described in the following with reference to the accompanying drawing. The figures of the drawing show:
- Fig. 1: schematically an arrangement 1 comprising a DC to AC converter and a converter control device,
- Fig. 2: schematically one of the electronic valves shown in Fig. 1 and details of the corresponding valve control unit,
- Fig. 3: details of valve control unit and
- Fig. 4: the valve current, the gate current and the collector-emitter voltage as functions of time in the course of a process of closing the valve.

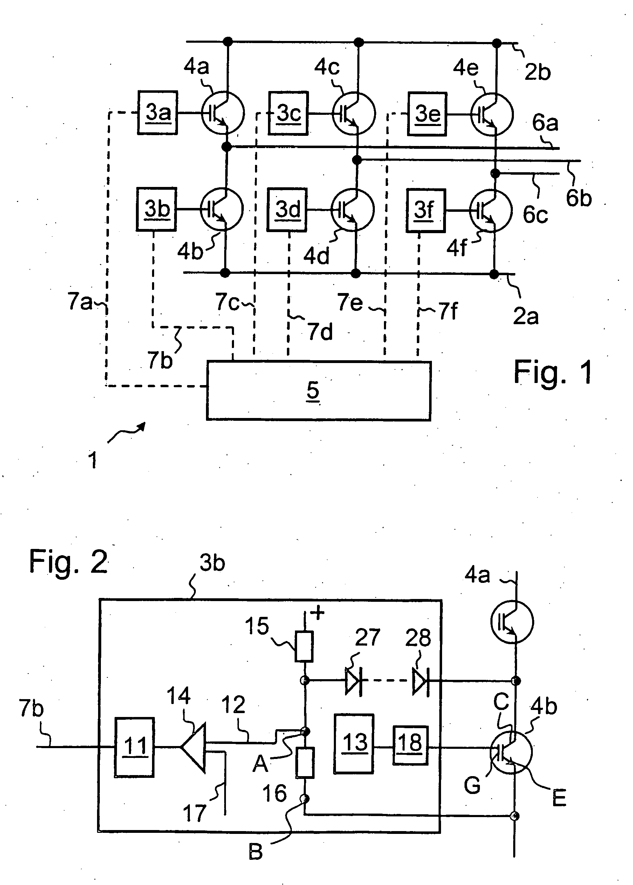

The DC to AC converter shown in Fig. 1 comprises six electronic valves 4a to 4f, which are IGBT's in the example. Each of the valves 4a to 4f is combined with a valve control unit 3a to 3f which is connected to the gate of the respective valve 4a to 4f.

The six valves 4a to 4f are arranged in three branches, wherein each of the branches comprises two of the valves 4a, 4b; 4c, 4d; 4e, 4f, which are connected in series to each other, so that each of the branches connects the electric lines 2a, 2b of a DC intermediate circuit. A contact (indicated by a small circle) in between the two valves of each branch is connected to one or three AC lines 6a, 6b, 6c.

A converter control device for controlling the operation of the valve control units 3a to 3f is connected to the valve control units 3a to 3f via signal lines 7a to 7f. During operation of the converter, the converter control device 5 outputs pulse signals to the valve control units 3a to 3f, in particular light pulse signals. For example, the respective valve control unit 3 is triggered to switch on the assigned valve 4, if the beginning of a light pulse is received by the valve control unit 3. If the light pulse terminates, the valve control unit 3 is triggered to switch off the assigned valve 4.

According to the present invention, each of the signal lines 7a to 7f can also be used for feedback of signals from the valve control units 3 to the converter control device 5, including signals which represent measurement values of the valve currents and of the measured voltage across the respective valve. Each of the signal lines 7a to 7f comprises a plurality of signal connections, for example a plurality of glass fibre cables.

Fig. 2 shows a preferred embodiment of the valve control units 3a to 3f, for example valve control unit 3b. For clarity reasons, Fig. 2 only shows components of the valve control unit 3b which are used for current measurement. Other components are omitted.

The valve control unit 3b comprises a resistive voltage divider, which comprises a series connection of two resistors 15, 16. The series connection is connected at one end to a plus potential of an energy supply of the control unit 3b. The other end of the series connection (connection point B, which might be connected to zero potential or ground) is connected to the side of the branch which is connected to DC line 2a. A connection point A in between the two resistors 15, 16 is connected to the branch of IGBTs 4a, 4b, namely to a contact point in between the IGBTs 4a, 4b. This connection between connection point A and the branch is made via at least one diode 27, 28, wherein point A is connected to the anode of the diode(s).

In the example shown, there is a series connection of two diodes 28, 29. In alternative embodiments, there might be more of diodes. Generally, the diode or diodes should be dimensioned so that they can resist the maximum possible voltage (inhibit a break-through) between the branch and point A, if the potential in the branch is higher than at point A. As long as the potential in the branch is lower than the potential at point A (which condition depends mainly on the level of the plus potential), the potential at point A is approximately equal to the potential in the branch between the two valves 4a, 4b. For example, the plus potential may be in the order of +20 V, the resistor 15 may have 1 kOhm and the resistor 16 may have 100 Ohms.

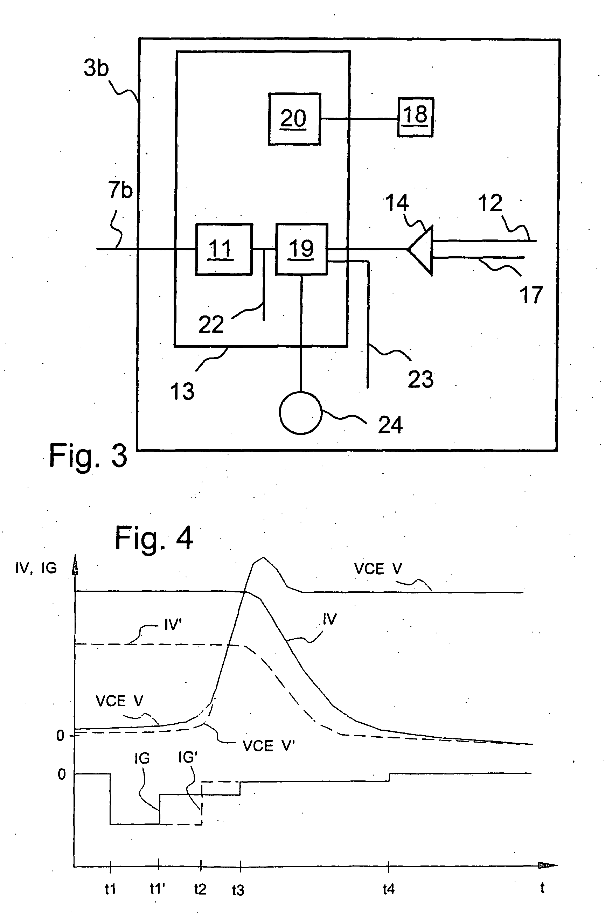

In the example shown in Fig. 2, the divided voltage across resistor 16, i.e. between contacts A, B, is fed to a comparator 14. This comparator compares the voltage signal in line 12 (which connects contact A with one input of comparator 14) with a reference signal in line 17 which is connected to a second input of comparator 14. The reference signal may be, for example, a voltage signal in the range of 5 to 15 volt, in particular 10 V (the maximum collector emitter voltage may be in range of some thousand Volts, when the valve is closed). A respective comparison signal is available at the output of comparator 14 and is transferred to a signal converter 11, which may be part of a digital processing unit 13 (Fig. 3) of the valve control unit 3b. An output of the signal converter 11 is connected to signal line 7b.

Furthermore, the valve control unit 3b comprises circuitry for controlling the current to and from the gate G of the valve 4b. This circuitry may be the digital processing unit 13 which includes the signal converter 11. The circuitry is connected to a current source amplifier 18 which is adapted to drive the current to and from a current source. In particular, it can produce a highly constant current.

Figure 3 shows details of a preferred embodiment of the valve control unit 3b. Same reference numerals refer to the same elements or devices as described in connection with figure 2. The reference 20 denotes an element of the digital processing unit 13, which may be realised by hardware and/or software that is adapted to control the current source amplifier 18.

The comparator 14 is connected to a first input of a counter 19. A second input of the counter 19 is connected to a clock 24 which periodically outputs clock signals at a constant frequency to the counter 19 and to other elements of the valve control unit 3b. A third input of the counter is provided for receiving a trigger signal which triggers the start of the process of closing the valve 4b. The same trigger signal may be received and used by other elements of the digital processing unit 13 for initiating the closing process. In particular, the trigger signal causes the element 20 to control the current source amplifier 18 so that the process of discharging the gate G is started. The trigger signal is produced by the converter control device 5 and is transferred via line 7b to valve control unit 3b (the connection of line 23 to line 7b is not shown in figure 3).

When the trigger signal is received by the counter 19, it starts a process of counting the clock signals. As soon as the comparator 14 detects that the signal in line 12 has reached the size of the reference signal in line 17, i.e. that the collector emitter voltage has reached the predetermined threshold value, the comparator 14 outputs a signal to the counter 19 which stops the counting process. The number of counted pulses corresponds to the length of the time interval during which the gate G is discharged using a constant current. Therefore, the number is a measure of the length and of the amount of charge which has been withdrawn from the gate G. According to the invention, this measure also corresponds to the valve current which was carried by the valve 4b immediately before the closing process started. Since the length of the time interval is typically in the range of some microseconds, a current of the same size continues at least during the first part of the time interval, until the valve begins to close.

The measure can be used internally by the digital processing unit 13 for controlling the valve 4b and is output to the signal converter 11 which outputs a corresponding converted signal to the converter control device via line 7b.

Figure 4 shows the development of the gate current IG, IG' and of the valve current IV, IV' in the course of two different processes of closing the valve. Furthermore, the voltage across the valve 4b (collector-emitter voltage VCE V) is shown. The time is denoted by t. The functions of the first process are denoted by IG, by IV and by VCE V. The time functions of the second process are denoted by IG', by IV' and by VCE V'. Both the first process and the second process may be one of a plurality of consecutive processes of closing the gate (i.e. switching off) during operation of the converter shown in figure 1. The first process and the second process are related to different operation phases of the valve. The continuous lines refer to the first process. Where the lines of the second process differ from the first process, the lines are dashed.

At the beginning of the first process, the valve current IV is significantly higher than the valve current IV' at the beginning of the second process. This means that a smaller amount of charge needs to be withdrawn from the gate before the valve starts closing in the first process compared to the second process. Since this information is known from preceding processes of closing the valve (for example from the process which was performed immediately before the first process), the gate current IG could be switched on earlier compared to the second process and with reference to the trigger signal which starts the process of closing the valve. However, as shown in figure 4, this is not the case in the example. Both processes are started at receipt of the trigger signal (at time t1). Alternatively, there might be a delay between receipt of the trigger signal and the start of the closing process. According to a further alternative, the converter control device may take the different valve current into account and may transfer the trigger signal which triggers the start of the discharging process earlier or later depending on the size of the valve current. In this case (which might correspond to the case shown in figure 4), the trigger signal may cause the valve control unit to start the discharging process without delay. Then, the receipt of the trigger signal can start the measurement of the time interval according the embodiment shown in figure 3.

In the case shown in figure 4, the measurement of the length of the time interval which is needed to withdraw the gate charge until the valve starts closing (the initial phase of closing process) is started at time t1 in both processes. In the first process, the time interval stops at time t1'. In the second process the time interval stops at time t2. In both cases the time interval stops when the collector emitter voltage reaches a predetermined threshold value or another predefined event occurs. However, the end of the time interval might differ in further processes of closing the valve, if the valve current is the same, but if the external operating conditions (e.g. temperature and the electric load connected to the valve) are changing. This means that it is possible to take these external operating conditions into account as well for controlling the process of closing the valve.

In order to clarify the terminology used herein: The closing process is started by discharging the gate when the valve is fully open and the gate (or more precisely: the gate charge) is saturated. Withdrawing some amount of the gate charge will not (or not significantly) influence the current carried by the valve. This means that during the initial phase (or first phase) of the closing process the valve is actually still fully open. Then, during the second phase which follows on to the first phase, further discharging of the gate results in a significant reduction of the current carried by the valve.

In any case, the length of the time interval (first phase) is measured and is taken into account during the following second phase of the closing process during which the valve closes.

In the second phase, the gate current IG, IG' is adapted depending on the measurement result. In the example shown in figure 4, the absolute value of the discharging current is higher in the first process during the second phase (i.e. there are higher negative values and a higher amount of charge is withdrawn from the gate per time unit). Consequently, the course of the collector emitter voltage (i.e. the time derivative of the collector emitter voltage, see VCE V and VCE V') can be controlled to be same in any process during the second phase.

The length of the interval [t1; t2] may be, for example, in the range of 1 to 5 microseconds. Using a digital clock which operates at standard clock frequencies, variations of the time interval can be determined with high precision. In the field of operating converters for high energy applications, such as providing energy to driving motors of railroad traction vehicles, the measured resolution of the valve current can be in range of 10 to 50 A for valve currents in the range of 200 to 5000 A, for example.

## Claims

1. A method of operating an electronic valve having an electrically insulated control electrode (gate G) which can be used to control a switching of the valve (4), in particular a method of operating an Insulated Gate Bipolar Transistor (IGBT), wherein
- when the valve (4) is fully open, a process of closing the valve (closing process) is started;
- an amount of a charge (gate charge), which is carried by the gate (G), is withdrawn from the gate (G) until the operating state of the valve (4) is affected;
- the withdrawn amount of the gate charge is measured; and
- the closing process and/or a closing process in a consecutive cycle of repeatedly closing and opening the valve is controlled depending on the measured amount.

2. A method of operating an electronic valve having an electrically insulated control electrode (gate G) which can be used to control a switching of the valve (4), in particular a method of operating an Insulated Gate Bipolar Transistor (IGBT), wherein
- when the valve (4) is fully open, a process of closing the valve (closing process) is started;
- an amount of a charge (gate charge), which is carried by the gate (G), is withdrawn from the gate (G) until a predetermined operating state of the valve (4) is reached;
- a time interval during which the amount of the gate charge is withdrawn from the gate is measured; and
- the closing process and/or a closing process in a consecutive cycle of repeatedly closing and opening the valve is controlled depending on the the measured time interval.

3. The method of one of the preceding claims, wherein the amount of the gate charge or the time interval is measured over or for an initial phase of the closing process, wherein a second phase (t2; t3) follows on to the initial phase (t1; t2) of the same closing process and wherein a discharging current which discharges the gate (G) in the second phase of the closing process is decreased compared to other closing processes of the valve (4), when a greater amount of the gate charge has been measured, and vice versa.

4. The method of one of the preceding claims, wherein the start of the time interval (t1; t2) is defined by a point in time (t1) when a valve control unit (3) receives a control signal that triggers the start of the closing process.

5. The method of one of the preceding claims, wherein the time interval (t1; t2) terminates, when a predetermined event occurs, and wherein the occurrence of the event is detected by a valve control unit (3) which controls the discharging of the gate (G).

6. The method of the preceding claim, wherein the charge carried by the gate (G) is saturated at the start of the time interval (t1; t2) and wherein the time interval (t1; t2) terminates, when the charge carried by the gate (G) is de-saturated.

7. The method of one of the two preceding claims, wherein the time interval (t1; t2) terminates, when a collector emitter voltage of the valve (4), which rises during the closing process, reaches a predetermined threshold value.

8. A method of measuring a current (valve current) which is carried by an electronic valve (4) having an electrically insulated control electrode (gate G) which can be used to control a switching of the valve (4), in particular of an Insulated Gate Bipolar Transistor (IGBT), wherein
- when the valve (4) is fully open, a process of closing the valve (closing process) is started;
- an amount of a charge (gate charge), which is carried by the gate, is withdrawn from the gate (G) until the operating state of the valve (4) is affected;
- the withdrawn amount of the gate charge is measured; and
- the valve current (IV) is determined depending on the measured amount.

9. A method of measuring a current (valve current) which is carried by an electronic valve (4) having an electrically insulated control electrode (gate G) which can be used to control a switching of the valve (4), in particular of an Insulated Gate Bipolar Transistor (IGBT), wherein
- when the valve (4) is fully open, a process of closing the valve (closing process) is started;
- an amount of a charge (gate charge), which is carried by the gate, is withdrawn from the gate (G) until a predetermined operating state of the valve (4) is reached;
- a time interval during which the amount of the gate charge is withdrawn from the gate is measured; and
- the valve current (IV) is determined depending on the time interval.

10. An arrangement of measuring a current (valve current) which is carried by an electronic valve (4) having an electrically insulated control electrode (gate G) which can be used to control a switching of the valve (4), in particular of an Insulated Gate Bipolar Transistor (IGBT), wherein the arrangement comprises:
- a discharging unit (18) which comprises a contact to be connected with the gate (G) and which is adapted to drive a discharging current (IG) from the gate;
- a measurement unit (19) which is adapted to measure an amount of a charge (gate charge) which is withdrawn from the gate (G) until the operating state of the valve (4) is affected;
- a starting unit (19) which is adapted to start the measurement of the amount, when the valve is fully open;
- a stopping unit (14, 19) which is adapted to stop the measurement of the amount, when a predetermined event occurs.

11. An arrangement of measuring a current (valve current) which is carried by an electronic valve (4) having an electrically insulated control electrode (gate G) which can be used to control a switching of the valve (4), in particular of an Insulated Gate Bipolar Transistor (IGBT), wherein the arrangement comprises:
- a discharging unit (18) which comprises a contact to be connected with the gate (G) and which is adapted to drive a discharging current (IG) from the gate;
- a measurement unit (19) which is adapted to measure a time interval during which the amount of the gate charge is withdrawn from the gate;
- a starting unit (19) which is adapted to start the measurement of the time interval, when the valve is fully open;
- a stopping unit (14, 19) which is adapted to stop the measurement of the time interval, when a predetermined operating state of the valve (4) is reached.

12. The arrangement of the preceding claim, comprising a valve control unit (3) which includes the measurement unit (19) or which is connected to the measurement unit and wherein the valve control unit (3) is adapted to control a process of closing the valve (4) by controlling a further discharging of the gate (G) depending on the result of the measurement performed by the measurement unit (19).

13. The arrangement of one of the preceding claims, wherein the measurement unit (19) comprises time measurement unit which is adapted to determine at least the end of a time interval, during which the amount of the gate charge is withdrawn from the gate (G).

14. An arrangement (1) of operating a converter, comprising of the arrangement of one of the preceding claims, wherein the converter (3, 4) comprises a plurality of electronic valves (4) which are repeatedly switched on and off during operation of the converter (3, 4) in order to perform a conversion, in particular a conversion of a direct current into an alternating current and/or vice versa, and wherein an output of the measurement unit (19) is connected to a converter control device (5) which is connected to each of a plurality of valve control units (3) and which is adapted to control an operation of the plurality of valve control units (3), thereby operating the converter (3, 4).

15. The arrangement of the preceding claim, wherein each of the valve control units (3) comprises the measurement unit (19).

## Patentansprüche

1. Verfahren zum Betreiben eines elektronischen Ventils, das eine elektrisch isolierte Steuerelektrode (Gate G) hat, die dazu nutzbar ist, ein Schalten des Ventils (4) zu steuern, insbesondere Verfahren zum Betreiben eines Insulated Gate Bipolar Transistor (IGBT), wobei
- wenn das Ventil (4) vollständig offen ist, ein Prozess eines Schließens des Ventils (Schließprozess) gestartet wird;
- eine Menge einer Ladung (Gateladung), die von dem Gate (G) getragen wird, von dem Gate (G) abgezogen wird, bis der Betriebszustand des Ventils (4) betroffen ist;
- die abgezogene Menge der Gateladung gemessen wird; und
- der Schließprozess und/oder ein Schließprozess in einem folgenden Zyklus eines wiederholten Schließens und Öffnens des Ventils abhängig von der gemessenen Menge gesteuert wird.

2. Verfahren zum Betreiben eines elektronischen Ventils, das eine elektrisch isolierte Steuerelektrode (Gate G) hat, die dazu nutzbar ist, ein Schalten des Ventils (4) zu steuern, insbesondere Verfahren zum Betreiben eines Insulated Gate Bipolar Transistor (IGBT), wobei
- wenn das Ventil (4) vollständig offen ist, ein Prozess eines Schließens des Ventils (Schließprozess) gestartet wird;
- eine Menge einer Ladung (Gateladung), die von dem Gate (G) getragen wird, von dem Gate (G) abgezogen wird, bis ein vorgegebener Betriebszustand des Ventils (4) erreicht ist;
- ein Zeitintervall, während dem die Menge der Gateladung von dem Gate abgezogen wird, gemessen wird; und
- der Schließprozess und/oder ein Schließprozess in einem folgenden Zyklus eines wiederholten Schließens und Öffnens des Ventils abhängig von dem gemessenen Zeitintervall gesteuert wird.

3. Verfahren nach einem der vorhergehenden Ansprüche, wobei die Menge der Gateladung oder das Zeitintervall über oder für eine Anfangsphase des Schließprozesses gemessen wird, wobei eine zweite Phase (t2; t3) auf die Anfangsphase (t1; t2) desselben Schließprozesses folgt und wobei ein Entladestrom, der das Gate (G) in der zweiten Phase des Schließprozesses entlädt, im Vergleich zu anderen Schließprozessen des Ventils (4) reduziert wird, wenn eine größere Menge der Gateladung gemessen worden ist, und umgekehrt.

4. Verfahren nach einem der vorhergehenden Ansprüche, wobei der Start des Zeitintervalls (t1; t2) durch einen Zeitpunkt (t1) definiert ist, wenn eine Ventil-Steuereinheit (3) ein Steuersignal empfängt, das den Start des Schließprozesses auslöst.

5. Verfahren nach einem der vorhergehenden Ansprüche, wobei das Zeitintervall (t1; t2) endet, wenn ein vorgegebenes Ereignis eintritt, und wobei das Eintreten des Ereignisses von einer Ventil-Steuereinheit (3) detektiert wird, die das Entladen des Gates (G) steuert.

6. Verfahren nach dem vorhergehenden Anspruch, wobei die Ladung, die von dem Gate (G) getragen wird, beim Start des Zeitintervalls (t1; t2) gesättigt ist und wobei das Zeitinterfall (t1; t2) endet, wenn die Ladung, die von dem Gate (G) getragen wird, entsättigt ist.

7. Verfahren nach einem der beiden vorhergehenden Ansprüche, wobei das Zeitintervall (t1; t2) endet, wenn eine Kollektor-Emitter-Spannung des Ventils (4), die während des Schließprozesses ansteigt, einen vorgegebenen Grenzwert erreicht.

8. Verfahren zum Messen eines Stroms (Ventilstrom), der von einem elektronischen Ventil (4) getragen wird, das eine elektrisch isolierte Steuerelektrode (Gate G) hat, die dazu nutzbar ist, ein Schalten des Ventils (4) zu steuern, insbesondere eines Insulated Gate Bipolar Transistor (IGBT), wobei
- wenn das Ventil (4) vollständig offen ist, ein Prozess eines Schließens des Ventils (Schließprozess) gestartet wird;
- eine Menge einer Ladung (Gateladung) die von dem Gate getragen wird, von dem Gate (G) abgezogen wird, bis der Betriebszustand des Ventils (4) betroffen ist;
- die abgezogene Menge der Gateladung gemessen wird; und
- der Ventilstrom (IV) abhängig von der gemessenen Menge bestimmt wird.

9. Verfahren zum Messen eines Stromes (Ventilstromes), der von einem elektronischen Ventil (4) getragen wird, das eine elektrisch isolierte Steuerelektrode (Gate G) hat, die dazu nutzbar ist, ein Schalten des Ventils (4) zu steuern, insbesondere eines Insulated Gate Bipolar Transistor (IGBP), wobei
- wenn das Ventil (4) vollständig offen ist, ein Prozess eines Schließens des Ventils (Schließprozess) gestartet wird;
- eine Menge einer Ladung (Gateladung), die von dem Gate getragen wird, von dem Gate (G) abgezogen wird, bis ein vorgegebener Betriebszustand des Ventils (4) erreicht ist;
- ein Zeitintervall, während dem die Menge der Gateladung von dem Gate abgezogen wird, gemessen wird; und
- der Ventilstrom (IV) abhängig von dem Zeitintervall bestimmt wird.

10. Anordnung zum Messen eines Stroms (Ventilstroms), der von einem elektronischen Ventil (4) geführt wird, das eine elektrisch isolierte Steuerelektrode (Gate G) hat, die dazu nutzbar ist, ein Schalten des Ventils (4) zu steuern, insbesondere eines Insulated Gate Bipolar Transistor (IGBT), wobei die Anordnung aufweist:
- eine Entladeeinheit (18), die einen Kontakt aufweist, der dazu dient, mit dem Gate (G) verbunden zu werden, und die dazu ausgestaltet ist, einen Entladestrom (IG) von dem Gate zu treiben;
- eine Messeinheit (19), die ausgestaltet ist, eine Menge einer Ladung (Gateladung) zu messen, die von dem Gate (G) abgezogen wird, bis der Betriebszustand des Ventils (4) betroffen ist;
- eine Starteinheit (19), die ausgestaltet ist, die Messung der Menge zu starten, wenn das Ventil vollständig offen ist;
- eine Stoppeinheit (14, 19), die dazu ausgestaltet ist, die Messung der Ladung zu stoppen, wenn ein vorgegebenes Ereignis eintritt.

11. Anordnung zum Messen eines Stromes (Ventilstrom), der von einem elektronischen Ventil (4) geführt wird, das eine elektrisch isolierte Steuerelektrode (Gate G) hat, die dazu nutzbar ist, ein Schalten des Ventils (4) zu steuern, insbesondere eines Insulates Gate Bipolar Transistor (IGBT), wobei die Anordnung aufweist:
- eine Entladeeinheit (18), die einen Kontakt aufweist, der dazu dient, mit dem Gate (G) verbunden zu werden, und die dazu ausgestaltet ist, einen Entladestrom (IG) von dem Gate zu treiben;
- eine Messeinheit (19), die dazu ausgestaltet ist, ein Zeitintervall zu messen, während dem die Menge der Gateladung von dem Gate abgezogen wird;
- eine Starteinheit (19), die dazu ausgestaltet ist, die Messung des Zeitintervalls zu starten, wenn das Ventil vollständig offen ist;
- eine Stoppeinheit (14, 19), die dazu ausgestaltet ist, die Messung des Zeitintervalls zu stoppen, wenn ein vorgegebener Betriebszustand des Ventils (4) erreicht ist.

12. Anordnung nach dem vorhergehenden Anspruch, aufweisend eine Ventil-Steuereinheit (3), die die Messeinheit (19) enthält oder die mit der Messeinheit verbunden ist, und wobei die Ventil-Steuereinheit (3) ausgestaltet ist, einen Prozess eines Schließens des Ventils (4) zu steuern, durch Steuern eines weiteren Entladens des Gate (G) abhängig von dem Ergebnis der Messung, die durch die Messeinheit (19) durchgeführt wird.

13. Anordnung nach einem der vorhergehenden Ansprüche, wobei die Messeinheit (19) eine Zeit-Messeinheit aufweist, die dazu ausgestaltet ist, zumindest das Ende des Zeitintervalls zu bestimmen, während dem die Menge der Gateladung von dem Gate (G) abgezogen wird.

14. Anordnung (1) zum Betreiben eines Konverters, aufweisend die Anordnung nach einem der vorhergehenden Ansprüche, wobei der Konverter (3, 4) eine Mehrzahl von elektronischen Ventilen (4) aufweist, die während eines Betriebes des Konverters (3, 4) wiederholt an- und ausgeschaltet werden, um eine Konversion durchzuführen, insbesondere eine Konversion eines Gleichstroms in einen Wechselstrom oder umgekehrt, und wobei ein Ausgang der Messeinheit (19) mit einer Konverter-Steuereinrichtung (5) verbunden ist, die mit jeder der Mehrzahl von Ventil-Steuereinheiten (3) verbunden ist und die dazu ausgestaltet ist, einen Betrieb der Mehrzahl von Ventil-Steuereinheiten (3) zu steuern und **dadurch** den Konverter (3, 4) zu betreiben.

15. Anordnung nach dem vorhergehenden Anspruch, wobei jede der Ventil-Steuereinheiten (3) die Messeinheit (19) aufweist.

## Revendications

1. Procédé de fonctionnement d'une valve électronique comportant une électrode de commande isolée électriquement (porte G) qui peut être utilisée pour commander une commutation de la valve (4), en particulier un procédé de fonctionnement d'un Transistor Bipolaire à Porte Isolée (IGBT), dans lequel :
- quand la valve (4) est totalement ouverte, un procédé de fermeture de la valve (procédé de fermeture) est démarré ;
- une quantité d'une charge (charge de porte), qui est supportée par la porte (G) est retirée de la porte (G) jusqu'à ce que l'état de fonctionnement de la valve (4) soit affecté ;
- la quantité retirée de la charge de porte est mesurée ; et
- le procédé de fermeture et/ou un procédé de fermeture dans un cycle consécutif de fermeture et ouverture répétées de la valve est contrôlé selon la quantité mesurée.

2. Procédé de fonctionnement d'une valve électronique comportant une électrode de commande isolée électriquement (porte G) qui peut être utilisée pour commander une commutation de la valve (4), en particulier un procédé de fonctionnement d'un Transistor Bipolaire à Porte Isolée (IGBT), dans lequel :
- quand la valve (4) est totalement ouverte, un procédé de fermeture de la valve (procédé de fermeture) est démarré ;
- une quantité d'une charge (charge de porte), qui est supportée par la porte (G), est retirée de la porte (G) jusqu'à ce qu'un état de fonctionnement prédéterminé de la valve (4) soit atteint ;
- un intervalle de temps pendant lequel la quantité de la charge de porte est retirée de la porte est mesuré ; et
- le procédé de fermeture et/ou un procédé de fermeture dans un cycle consécutif de fermeture et d'ouverture répétées de la valve est contrôlé selon l'intervalle de temps mesuré.

3. Procédé selon l'une quelconque des revendications précédentes, dans lequel la quantité de la charge de porte ou l'intervalle de temps est mesuré sur ou pour une phase initiale du procédé de fermeture, dans lequel une seconde phase (t2 ; t3) suit la phase initiale (t1 ; t2) du même procédé de fermeture et dans lequel un courant de décharge qui décharge la porte (G) dans la seconde phase du procédé de fermeture est réduit en comparaison avec d'autres procédés de fermeture de la valve (4), quand une quantité supérieure de la charge de porte a été mesurée, et vice versa.

4. Procédé selon l'une quelconque des revendications précédentes, dans lequel le début de l'intervalle de temps (t1 ; t2) est défini par un point dans le temps (t1) quand une unité de commande de valve (3) reçoit un signal de commande qui déclenche le début du procédé de fermeture.

5. Procédé selon l'une quelconque des revendications précédentes, dans lequel l'intervalle de temps (t1 ; t2 se termine, quand un événement prédéterminé survient, et dans lequel la survenue de l'événement est détectée par une unité de commande de valve (3) qui commande la décharge de la porte (G).

6. Procédé selon la revendication précédente, dans lequel la charge supportée par la porte (G) est saturée au début de l'intervalle de temps (t1 ; t2) et dans lequel l'intervalle de temps (t1 ; t2) se termine, quand la charge supportée par la porte (G) est désaturée.

7. Procédé selon l'une quelconque des deux revendications précédentes, dans lequel l'intervalle de temps (t1 ; t2) se termine, quand une tension collecteur-émetteur de la valve (4), qui augmente pendant le procédé de fermeture, atteint une valeur de seuil prédéterminée.

8. Procédé de mesure d'un courant (courant de valve) supporté par une valve électronique (4) comportant une électrode de commande isolée électriquement (porte G) qui peut être utilisée pour commander une commutation de la valve (4), en particulier d'un Transistor Bipolaire à Porte Isolée (IGBT), dans lequel :
- quand la valve (4) est totalement ouverte, un procédé de fermeture de la valve (procédé de fermeture) est démarré ;
- une quantité d'une charge (charge de porte), qui est supportée par la porte, est retirée de la porte (G) jusqu'à ce que l'état de fonctionnement de la valve (4) soit affecté ;
- la quantité retirée de la charge de porte est mesurée ; et
- le courant de valve (IV) est déterminé selon la quantité mesurée.

9. Procédé de mesure d'un courant (courant de valve) supporté par une valve électronique (4) comportant une électrode de commande isolée électriquement (porte G) qui peut être utilisée pour commander une commutation de la valve (4), en particulier d'un Transistor Bipolaire à Porte Isolée (IGBT), dans lequel :
- quand la valve (4) est totalement ouverte, un procédé de fermeture de la valve (procédé de fermeture) est démarré ;
- une quantité d'une charge (charge de porte), qui est supportée par la porte, est retirée de la porte (G) jusqu'à ce qu'un état de fonctionnement prédéterminé de la valve (4) soit atteint ;
- un intervalle de temps pendant lequel la quantité de la charge de porte est retirée de la porte est mesuré ; et
- le courant de valve (IV) est déterminé selon l'intervalle de temps.

10. Dispositif de mesure d'un courant (courant de valve) supporté par une valve électronique (4) comportant une électrode de commande isolée électriquement (porte G) qui peut être utilisée pour commander une commutation de la valve (4), en particulier d'un Transistor Bipolaire à Porte Isolée (IGBT), dans lequel le dispositif comprend :
- une unité de décharge (18) comprenant un contact pour être reliée à la porte (G) et adaptée pour transporter un courant de décharge (IG) depuis la porte ;
- une unité de mesure (19) adaptée pour mesurer une quantité d'une charge (charge de porte) qui est retirée de la porte (G) jusqu'à ce que l'état de fonctionnement de la valve (4) soit affecté ;
- une unité de démarrage (19) adaptée pour démarrer la mesure de la quantité, quand la valve est totalement ouverte ;
- une unité d'arrêt (14, 19) adaptée pour arrêter la mesure de la quantité, quand un événement prédéterminé survient.

11. Dispositif de mesure d'un courant (courant de valve) supporté par une valve électronique (4) comportant une électrode de commande isolée électriquement (porte G) qui peut être utilisée pour commander une commutation de la valve (4), en particulier d'un Transistor Bipolaire à Porte Isolée (IGBT), dans lequel le dispositif comprend :
- une unité de décharge (18) comprenant un contact pour être reliée à la porte (G) et adaptée pour transporter un courant de décharge (IG) depuis la porte ;
- une unité de mesure (19) adaptée pour mesurer un intervalle de temps pendant lequel la quantité de la charge de porte est retirée de la porte ;
- une unité de démarrage (19) adaptée pour démarrer la mesure de l'intervalle de temps, quand la valve est totalement ouverte ;
- une unité d'arrêt (14, 19) adaptée pour arrêter la mesure de l'intervalle de temps, quand un état de fonctionnement prédéterminé de la valve (4) est atteint.

12. Dispositif selon la revendication précédente, comprenant une unité de commande de valve (3) qui comprend l'unité de mesure (19) ou qui est reliée à l'unité de mesure et dans lequel l'unité de commande de valve (3) est adaptée pour commander un procédé de fermeture de la valve (4) en contrôlant une décharge supplémentaire de la porte (G) selon le résultat de la mesure réalisée par l'unité de mesure (19).

13. Dispositif selon l'une quelconque des revendications précédentes, dans lequel l'unité de mesure (19) comprend une unité de mesure de temps adaptée pour déterminer au moins la fin d'un intervalle de temps pendant lequel la quantité de la charge de porte est retirée de la porte (G).

14. Dispositif (1) de fonctionnement d'un convertisseur, comprenant le dispositif selon l'une quelconque des revendications précédentes, dans lequel le convertisseur (3, 4) comprend une pluralité de valves électroniques (4) mises en marche et éteintes répétitivement pendant le fonctionnement du convertisseur (3, 4) afin de réaliser une conversion, en particulier une conversion d'un courant continu en courant alternatif et/ou vice versa, et dans lequel une sortie de l'unité de mesure (19) est reliée à un dispositif de commande du convertisseur (5) relié à chacune d'une pluralité d'unités de commande de valve (3) et adapté pour commander le fonctionnement de la pluralité d'unités de commande de valve (3), faisant ainsi fonctionner le convertisseur (3, 4).

15. Dispositif selon la revendication précédente, dans lequel chacune des unités de commande de valve (3) comprend l'unité de mesure (19).
